# EUROPEAN PATENT APPLICATION

(11) **EP 4 084 332 A1**
(43) Date of publication of application: **02.11.2022**
(21) Application number: 20907583.7
(22) Date of filing: 06.05.2020
(51) Int. Cl.: H03H 9/17, H03H 9/02

(54) **REFLECTIONLESS FILTER AND ELECTRONIC DEVICE**

(30) Priority: 24.12.2019 CN 201911344202
(71) Applicant: Rofs Microsystem (Tianjin) Co., Ltd, Tianjin 300462 (CN)
(72) Inventor: YANG, Qingrui, Tianjin 300072 (CN); PANG, Wei, Tianjin 300072 (CN)
(74) Representative: Bandpay & Greuter
(86) International application number: PCT/CN2020/088718
(87) International publication number: WO 2021/128694

(57) **Abstract**

The present disclosure relates to a reflectionless filter, including: a symmetrical two-port circuit, the circuit including series resonator branches and multiple parallel resonator branches, each series resonator branch being provided with a series resonator unit, and each parallel resonator branch being provided with a parallel resonator unit, wherein the series resonator unit includes a parallel module formed by a bulk acoustic resonator and an inductor connected in parallel with each other, and the parallel resonator unit of each of at least two parallel resonator branches includes a series module formed by a bulk acoustic resonator and an inductor connected in series with each other. The present disclosure also relates to an electronic device having the reflectionless filter.

## Description

### TECHNICAL FIELD

Embodiments of the present disclosure relate to the field of semiconductors, and in particular, to a reflectionless filter and an electronic device having the reflectionless filter.

### BACKGROUND

A Film Bulk Acoustic Resonator (FBAR) is very important in the field of communication when used as a MEMS chip. Traditional surface acoustic wave (SAW) filters and ceramic filters are gradually replaced by the FBAR filters due to their small size (µm level), high resonant frequency (GHz), high quality factor (1000), large power capacity, good roll-off effect, and other excellent characteristics. Such the FBAR filters are used widely in the field of wireless communication radio frequency, and can be also applicable to the sensing filed such as biology, physics, and medicine due to their high sensitivity.

The film bulk acoustic resonator is used in a bulk acoustic wave filter. The bulk acoustic wave filter is widely used in the current wireless communication systems due to its advantages of low insertion loss, high rectangular coefficient, high power capacity and the like, which is an important element to determine quality of a radio frequency signal being transmitted into and from a communication system.

FIG. 9 is an abstract circuit diagram of a filter with a Ladder topology (a common structure). As shown in FIG. 9, the filter includes an input terminal (Input) and an output terminal (Output), four series bulk acoustic wave resonators Rs1 to 4 located between the output terminal and the input terminal, and three parallel bulk acoustic wave resonators Rp1 to 3 located between the series bulk acoustic wave resonators and ground terminals (GNDs).

In the present disclosure, the "Input" represents an input port and the "Output" represents an output port.

FIG. 10 is an abstract circuit diagram of a filter with a Lattice topology (a common structure) in the related art. Input1 and Input2 represent input ports, Output1 and Output2 represent output ports, Rp1 and Rp2 represent parallel resonators, and Rs1 and Rs2 represent series resonators.

FIG. 11 shows a graph of frequency-insertion loss of common filters in FIGS. 9 and 10.

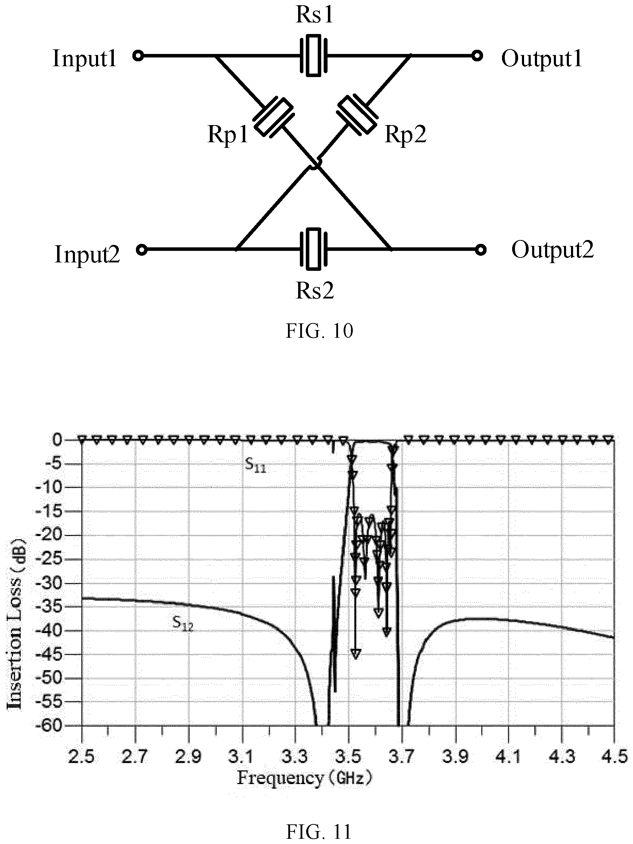

As shown in FIG. 11, a reflection coefficient within a passband is low, but is high beyond the passband (in a stopband) with strong reflection. That is, an input electrical signal at the input terminal is transmitted to the output terminal if it is located within the passband, it is, and it is totally reflected to the input terminal without signal output at the output terminal if it is located within the stopband. When the reflected signal with a high power is returned to the input terminal, the reflected signal may disadvantageously affect subsequent circuits after being transmitted back to the input terminal, thereby destroying stability of the active circuit. In addition, inter-stage reflection degrades the response of the filter, the inter-stage reflection cannot be enhanced by direct cascading, performance of a terminal mixer at an out-of-band port of a reflective filter is sensitive, and performance of the system is influenced by a reactive terminal within its stopband. Hence, a reflectionless filter system is demanded increasingly.

A filter having a traditional bulk acoustic wave resonator cannot be implemented for some special situations which require low reflection or even no reflection in a full band. In recent years, with development and wide application of the bulk acoustic wave resonator, it is greatly required to develop and realize a reflectionless filter based on a bulk acoustic wave resonator with customized response, which is also an acknowledged technical problem in this industry.

### SUMMARY

In order to realize a reflectionless filter based on a bulk acoustic wave resonator, the present disclosure is proposed.

According to an aspect of embodiments of the present disclosure, there is provided a bulk acoustic wave resonator that includes a symmetrical two-port circuit. The symmetrical two-port circuit includes a plurality of series resonator branches and a plurality of parallel resonator branches. Each of the plurality of series resonator branches is provided with a series resonator unit, and each of the plurality of parallel resonator branches is provided with a parallel resonator unit.

The series resonator unit includes a parallel module formed by a bulk acoustic wave resonator and an inductor that are connected in parallel to each other, and the parallel resonator units of at least two of the plurality of parallel resonator branches each include a series module formed by a bulk acoustic wave resonator and an inductor that are connected in series to each other.

Alternatively, the series resonator unit includes a series module formed by a bulk acoustic wave resonator and an inductor that are connected in series to each other, and the parallel resonator units of at least two of the plurality of parallel resonator branches each include a parallel module formed by a bulk acoustic wave resonator and an inductor that are connected in parallel to each other.

According to another aspect of the embodiments of the present disclosure, an electronic device is proposed, which includes the reflectionless filter described above.

### BRIEF DESCRIPTION OF DRAWINGS

The following description and drawings can facilitate to understand these and other features and advantages in various embodiments disclosed in the present disclosure. The same reference signs in the drawings always indicate the same components, wherein:

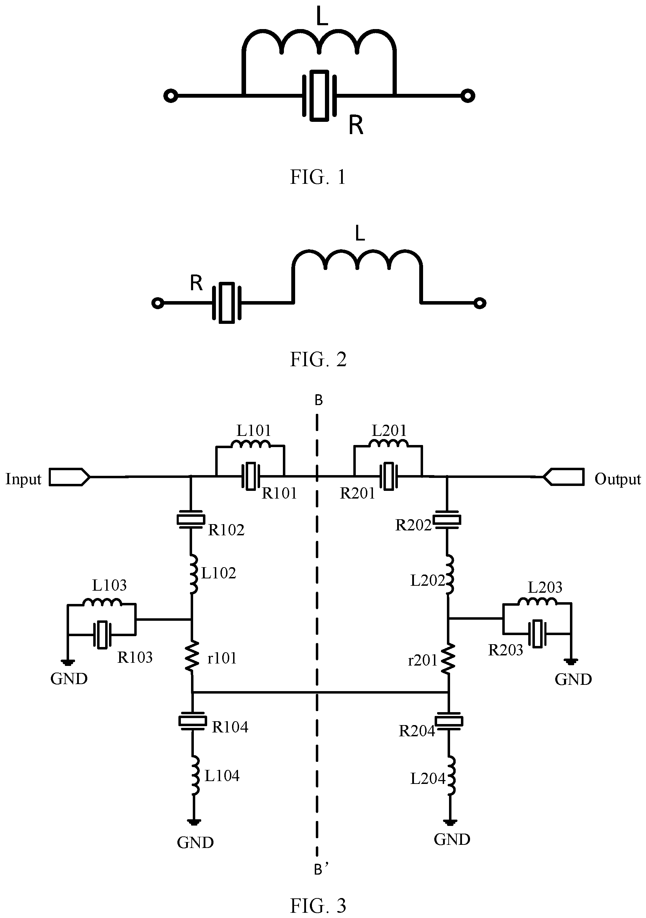

FIG. 1 is a circuit structural diagram of a parallel module formed by a bulk acoustic wave resonator and an inductor that are connected to each other in parallel according to an exemplary embodiment of the present disclosure;
FIG. 2 is a circuit structural diagram of a series module formed by a bulk acoustic wave resonator and an inductor that are connected to each other in series according to an exemplary embodiment of the present disclosure;
FIG. 3 is a circuit structural diagram of a reflectionless filter according to an exemplary embodiment of the present disclosure;

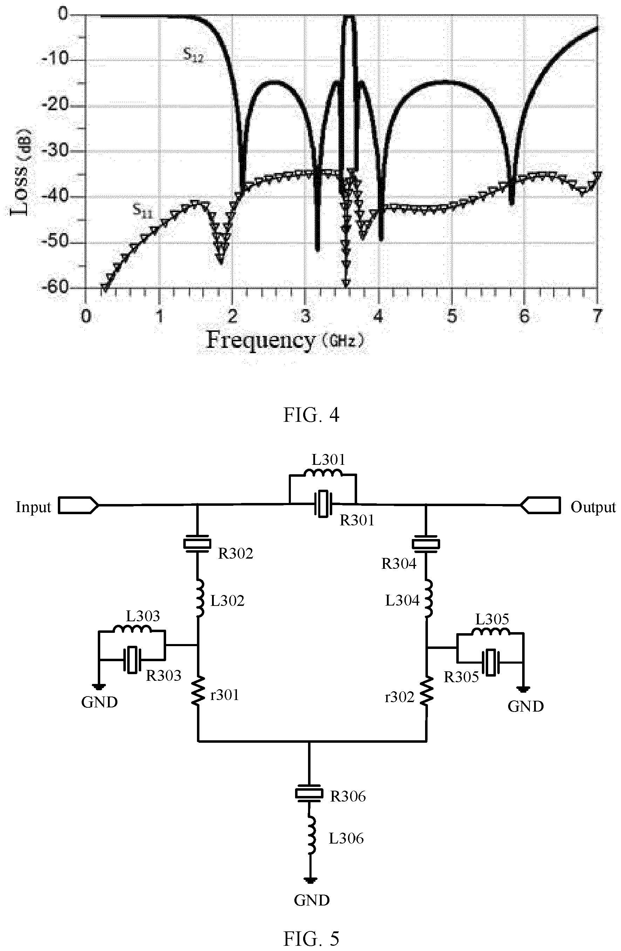

FIG. 4 is a graph of transmission characteristics and reflection characteristics of a reflectionless filter based on a structure in FIG. 3 according to an embodiment of the present disclosure;
FIG. 5 is a circuit structural diagram of a reflectionless filter according to another exemplary embodiment of the present disclosure;

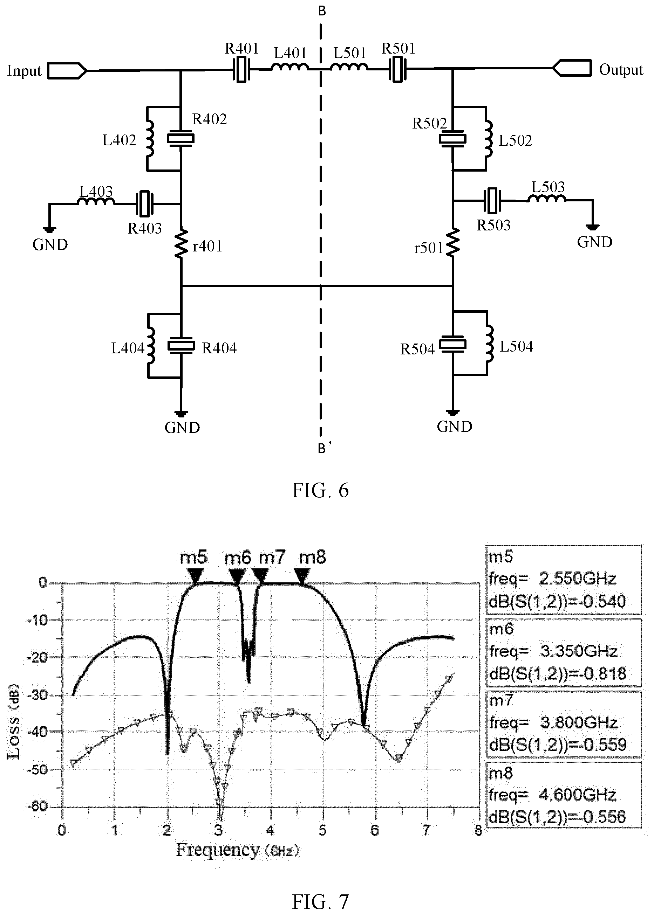

FIG. 6 is a circuit structural diagram of a reflectionless filter according to yet another exemplary embodiment of the present disclosure;
FIG. 7 is a graph of transmission characteristics and reflection characteristics of a reflectionless filter based on a structure in FIG. 6 according to an embodiment of the present disclosure;

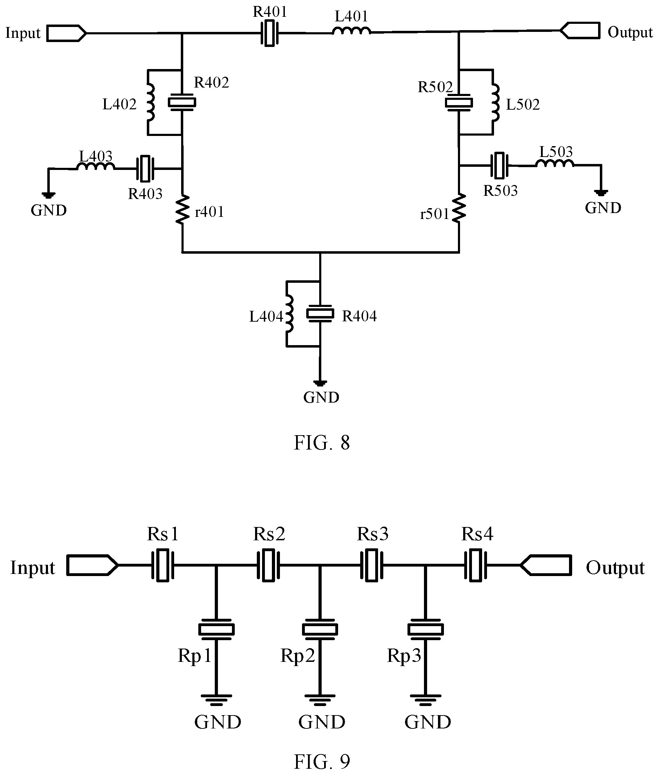

FIG. 8 is a circuit structural diagram of a reflectionless filter according to still another exemplary embodiment of the present disclosure;
FIG. 9 is an abstract circuit diagram of a filter with a ladder topology in the related art;
FIG. 10 is an abstract circuit diagram of a filter with a lattice topology in the related art; and
FIG. 11 is a graph of transmission characteristics and reflection characteristics of the filters in FIGS. 9 and 10.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

FIG. 1 is a circuit structural diagram of a parallel module formed by a bulk acoustic wave resonator R and an inductor L that are connected to each other in parallel according to an exemplary embodiment of the present disclosure. FIG. 2 is a circuit structural diagram of a series module formed by a bulk acoustic wave resonator R and an inductor L that are connected to each other in series according to an exemplary embodiment of the present disclosure.

FIG. 3 is a circuit structural diagram of a reflectionless filter according to an exemplary embodiment of the present disclosure. In FIG. 3, the circuit structure is divided into a left portion and a right portion by a dotted line B-B' in FIG. 3, which are symmetrical relative to each other. The circuit structure includes an input port (Input) and an output port (Output). The left portion includes four bulk acoustic wave resonators R101, R102, R103 and R104, four inductors L101, L102, L103 and L104, and a resistor r101.

The resonator R101, the inductor L101, the resonator R103 and the inductor L103 form a parallel module to achieve parallel inductance on the bulk acoustic wave resonator. The resonator R102, the inductor L102, the resonator R104 and the inductor L104 form a series module to achieve series inductance on the bulk acoustic wave resonator.

In the present disclosure, the left-right symmetry of the circuit structure means not only structural symmetry, but also numerical symmetry. That is, values of components arranged at symmetrical positions are the same.

Specifically, the left portion of the circuit structure includes a first series resonator unit, a first parallel resonator unit, a second parallel resonator unit, a resistance element or resistor r101, and a third parallel resonator unit.

The first series resonator unit includes a parallel module formed by the bulk acoustic wave resonator R101 and the inductor L101, which are connected in parallel to each other.

The first parallel resonator unit includes a series module formed by the bulk acoustic wave resonator R102 and the inductor L102, which are connected in series to each other.

The second parallel resonator unit includes a series module formed by the bulk acoustic wave resonator R104 and the inductor L104, which are connected in series to each other.

One end of the first parallel resonator unit is connected between the input port and the first series resonator unit, and the other end of the first parallel resonator unit is connected to one end of the resistance element r101. The other end of the resistance element r101 is connected to one end of the second parallel resonator unit, and the other end of the second parallel resonator unit is grounded (GND).

The third parallel resonator unit includes a parallel module formed by the bulk acoustic wave resonator R103 and the inductor L103, which are connected in parallel to each other. One end of the third parallel resonator unit is connected between the other end of the first parallel resonator unit and the one end of the resistance element r101, and the other end of the third parallel resonator unit is grounded.

In addition, as shown in FIG. 3, the other end of the resistance element r101 and the other end of a resistance element r201 are electrically connected to each other.

FIG. 4 shows a graph of transmission characteristics and reflection characteristics of a reflectionless filter based on a structure in FIG. 3 according to an embodiment of the present disclosure.

It can be seen from FIG. 4 that return loss of a port reflection coefficient S11 of a single-stage filter in a full band is -35 dB or less.

In addition, as can be seen from FIG. 4, the circuit structure in FIG. 3 can achieve low-pass, band-pass, and high-pass characteristics.

FIG. 5 is a circuit structural diagram of a reflectionless filter according to another exemplary embodiment of the present disclosure. FIG. 5 is a simplified diagram of circuit elements of the circuit structure in FIG. 3. In FIG. 5, the two parallel modules connected between the two ports are combined into one parallel module, and second ends of the resistance elements or the resistors are connected to one parallel resonator unit. Specifically, the circuit structure in FIG. 5 includes a first series resonator unit, a first parallel resonator unit, a first resistance element r301, a second parallel resonator unit, a second resistance element r302, a third parallel resonator unit, a fourth parallel resonator unit, and a fifth parallel resonator unit.

The first series resonator unit is connected between an input port and an output port. The first series resonator unit includes a parallel module formed by a bulk acoustic wave resonator R301 and an inductor L301, which are connected in parallel to each other.

The first parallel resonator unit includes a series module formed by a bulk acoustic wave resonator R302 and an inductor L302, which are connected in series to each other. One end of the first parallel resonator unit is connected between the input port and the first series resonator unit, and the other end of the first parallel resonator unit is connected to one end of the first resistance element r301.

The second parallel resonator unit includes a series module formed by a bulk acoustic wave resonator R304 and an inductor L304, which are connected in series to each other. One end of the second parallel resonator unit is connected between the output port and the first series resonator unit, and the other end of the second parallel resonator unit is connected to one end of the second resistance element r302.

The third parallel resonator unit includes a series module formed by a bulk acoustic wave resonator R306 and an inductor L306, which are connected in series to each other. One end of the third parallel resonator unit is connected to the other end of the first resistor r301 and the other end of the second resistor r302, and the other end of the third parallel resonator unit is grounded.

The fourth parallel resonator unit includes a parallel module formed by a bulk acoustic wave resonator R303 and an inductor L303, which are connected in parallel to each other. One end of the fourth parallel resonator unit is connected between the other end of the first parallel resonator unit and the one end of the first resistance element, and the other end of the fourth parallel resonator unit is grounded.

The fifth parallel resonator unit includes a parallel module formed by a bulk acoustic wave resonator R305 and an inductor L305, which are connected in parallel to each other. One end of the fifth parallel resonator unit is connected between the other end of the second parallel resonator unit and the one end of the second resistance element, and the other end of the fifth parallel resonator unit is grounded.

FIG. 6 is a circuit structural diagram of a reflectionless filter according to yet another exemplary embodiment of the present disclosure. FIG. 6 differs from FIG. 3 in that positions of the series modules and the parallel modules in FIG. 3 and FIG. 6 are interchanged.

In FIG. 6, the circuit structure is divided into a left portion and a right portion by a dotted line B-B' in FIG. 6, which are symmetrical relative to each other. The circuit structure includes an input port (Input) and an output port (Output). The left portion includes four bulk acoustic wave resonators R401, R402, R403 and R404, four inductors L401, L402, L403 and L404, and a resistor r401.

The resonator R401, the inductor L401, the resonator R403 and the inductor L403 form a series module to achieve series inductance on the bulk acoustic wave resonator. The resonator R402, the inductor L402, the resonator R404 and the inductor L404 form a parallel module to achieve parallel inductance on the bulk acoustic wave resonator.

Specifically, the left portion of the circuit structure includes a first series resonator unit, a first parallel resonator unit, a second parallel resonator unit, a resistance element or resistor r401, and a third parallel resonator unit.

The first series resonator unit includes a series module formed by the bulk acoustic wave resonator R401 and the inductor L401, which are connected in series to each other.

The first parallel resonator unit includes a parallel module formed by the bulk acoustic wave resonator R402 and the inductor L402, which are connected in parallel to each other.

The second parallel resonator unit includes a parallel module formed by the bulk acoustic wave resonator R404 and the inductor L404, which are connected in parallel to each other.

One end of the first parallel resonator unit is connected between the input port and the first series resonator unit, and the other end of the first parallel resonator unit is connected to one end of the resistance element r401. The other end of the resistance element r401 is connected to one end of the second parallel resonator unit, and the other end of the second parallel resonator unit is grounded (GND).

The third parallel resonator unit includes a series module formed by the bulk acoustic wave resonator R403 and the inductor L403, which are connected in series to each other. One end of the third parallel resonator unit is connected between the other end of the first parallel resonator unit and the one end of the resistance element r401, and the other end of the third parallel resonator unit is grounded.

In addition, as shown in FIG. 6, the other end of the resistance element r401 and the other end of a resistance element r501 are electrically connected to each other.

FIG. 7 shows a graph of transmission characteristics and reflection characteristics of a reflectionless filter based on a structure in FIG. 7 according to an embodiment of the present disclosure.

It can be seen from FIG. 7 that return loss of a port reflection coefficient S11 of a single-stage filter in a frequency band of 0 to 6.5 GHz is -35 dB or less.

In addition, as can be seen from FIG. 7, the circuit structure in FIG. 6 can realize dual-bandpass characteristics. In other words, the filter in FIG. 6 is a dual-bandpass filter.

FIG. 8 is a circuit structural diagram of a reflectionless filter according to another exemplary embodiment of the present disclosure. FIG. 8 is a simplified diagram of circuit elements of the circuit structure in FIG. 6. In FIG. 8, two series modules are combined into one series module, and second ends of resistance elements or resistors are connected to a parallel resonator unit. Specifically, the circuit structure in FIG. 8 includes a first series resonator unit, a first parallel resonator unit, a first resistance element r401, a second parallel resonator unit, a second resistance element r501, a third parallel resonator unit, a fourth parallel resonator unit, and a fifth parallel resonator unit.

The first series resonator unit is connected between an input port and an output port. The first series resonator unit includes a series module formed by a bulk acoustic wave resonator R401 and an inductor L401, which are connected in series to each other.

The first parallel resonator unit includes a parallel module formed by a bulk acoustic wave resonator R402 and an inductor L402, which are connected in parallel to each other. One end of the first parallel resonator unit is connected between the input port and the first series resonator unit, and the other end of the first parallel resonator unit is connected to one end of the first resistance element r401.

The second parallel resonator unit includes a parallel module formed by a bulk acoustic wave resonator R502 and an inductor L502, which are connected in parallel to each other. One end of the second parallel resonator unit is connected between the output port and the first series resonator unit, and the other end of the second parallel resonator unit is connected to one end of the second resistance element r501.

The third parallel resonator unit includes a parallel module formed by a bulk acoustic wave resonator R404 and an inductor L404, which are connected in parallel to each other. One end of the third parallel resonator unit is connected to the other end of the first resistor r401 and the other end of the second resistance element r501, and the other end of the third parallel resonator unit is grounded.

The fourth parallel resonator unit includes a series module formed by a bulk acoustic wave resonator R403 and an inductor L403, which are connected in series to each other. One end of the fourth parallel resonator unit is connected between the other end of the first parallel resonator unit and the one end of the first resistance element, and the other end of the fourth parallel resonator unit is grounded.

The fifth parallel resonator unit includes a series module formed by a bulk acoustic wave resonator R503 and an inductor L503, which are connected in series to each other. One end of the fifth parallel resonator unit is connected between the other end of the second parallel resonator unit and the one end of the second resistance element, and the other end of the fifth parallel resonator unit is grounded.

Although not shown, the reflectionless filter according to the present disclosure can be used in combination with an LC reflectionless bandpass filter in the related art. Accordingly, the present disclosure provides a filter assembly that includes an input port, an output port, an LC reflectionless bandpass filter, and the above reflectionless filter. At least one reflectionless filter (or a plurality of reflectionless filters in cascaded form) and the LC bandpass filter are sequentially connected in series between the input port and the output port.

In an embodiment of the present disclosure, resistance of the resistance elements are equivalent to or the same as port impedance at the ports. For example, the port impedance is 50 Ohm, and the resistance of the two resistance elements are also 50 Ohm. "Equivalent" herein means that a difference between them is no more than 10%.

In the present disclosure, a plurality of the reflectionless filters described above are cascaded to form a cascaded unit of the reflectionless filters.

In view of above embodiments and the drawings thereof, the present disclosure provides following technical solutions.
1. A reflectionless filter includes:
   a symmetrical two-port circuit including a plurality of series resonator branches and a plurality of parallel resonator branches, each of the plurality of series resonator branches being provided with a series resonator unit, and each of the plurality of parallel resonator branches being provided with a parallel resonator unit,
   wherein
      each of the plurality of series resonator unit includes a parallel module formed by a bulk acoustic wave resonator and an inductor that are connected in parallel to each other, and the parallel resonator units of at least two of the plurality of parallel resonator branches each include a series module formed by a bulk acoustic wave resonator and an inductor that are connected in series to each other.
2. The reflectionless filter according to 1, wherein
   two parallel resonator branches of the plurality of parallel resonator branches arranged at two symmetrical sides of the symmetrical two-port circuit each include a resistance element connected between two parallel resonator units of the two parallel resonator branches.
3. The reflectionless filter according to 1, wherein
   one parallel resonator branch of the plurality of parallel resonator branches arranged at each of two symmetrical sides of the symmetrical two-port circuit includes a parallel resonator, the parallel resonator includes a parallel module formed by a bulk acoustic wave resonator and an inductor that are connected in parallel to each other, one end of the one parallel resonator branch is grounded, and another end of the one parallel resonator branch is connected to one of the plurality of series resonator branches through the parallel resonator unit including the series module.
4. The reflectionless filter according to 1, wherein
   at each of two symmetrical sides of the symmetrical two-port circuit, the symmetrical two-port circuit includes:
      a first series resonator unit that is one of two series resonator units of the plurality of series resonator unit, the two series resonator units being connected in series between two ports of the symmetrical two-port circuit;
      a first parallel resonator unit, a second parallel resonator unit and a resistance element, wherein one end of the first parallel resonator unit is connected between a corresponding one of the two ports and the first series resonator unit, another end of the first parallel resonator unit is connected to one end of the resistance element, another end of the resistance element is connected to one end of the second parallel resonator unit, and another end of the second parallel resonator unit is grounded; and
      a third parallel resonator unit, one end of the third parallel resonator unit being connected between another end of the first parallel resonator unit and the one end of the resistance element, and another end of the third parallel resonator unit being grounded; and
   the another ends of the resistance elements at the two symmetrical sides are electrically connected to each other.
5. The reflectionless filter according to 1, wherein
   the symmetrical two-port circuit includes:
   a first series resonator unit connected between a first port and a second port;
   a first parallel resonator unit and a first resistance element, one end of the first parallel resonator unit being connected between the first port and the first series resonator unit, and another end of the first parallel resonator unit being connected to one end of the first resistance element;
   a second parallel resonator unit and a second resistance element, one end of the second parallel resonator unit being connected between the second port and the first series resonator unit, and another end of the second parallel resonator unit being connected to one end of the second resistance element;
   a third parallel resonator unit, one end of the third parallel resonator unit being connected with both another end of the first resistance element and another end of the second resistance element, and another end of the third parallel resonator unit being grounded;
   a fourth parallel resonator unit, one end of the fourth parallel resonator unit being connected between the another end of the first parallel resonator unit and the one end of the first resistance element, and another end of the fourth parallel resonator unit being grounded; and
   a fifth parallel resonator unit, one end of the fifth parallel resonator unit being connected between the another end of the second parallel resonator unit and the one end of the second resistance element, and another end of the fifth parallel resonator unit being grounded.
6. A reflectionless filter includes:
   a symmetrical two-port circuit including a plurality of series resonator branches and a plurality of parallel resonator branches, each of the plurality of series resonator branches being provided with a series resonator unit, and each of the plurality of parallel resonator branches being provided with a parallel resonator unit,
   wherein
      the series resonator unit includes a series module formed by a bulk acoustic wave resonator and an inductor that are connected in series to each other, and the parallel resonator units of at least two of the plurality of parallel resonator branches each include a parallel module formed by a bulk acoustic wave resonator and an inductor that are connected in parallel to each other.
7. The reflectionless filter according to 6, wherein
   two parallel resonator branches of the plurality of parallel resonator branches arranged at two symmetrical sides of the symmetrical two-port circuit each include a resistance element connected between two parallel resonator units of the two parallel resonator branches.
8. The reflectionless filter according to 6, wherein
   one of parallel resonator branches of the plurality of parallel resonator branches arranged at each of two symmetrical sides of the symmetrical two-port circuit is provided with a parallel resonator, the parallel resonator includes a series module formed by a bulk acoustic wave resonator and an inductor that are connected in series to each other, one end of the one parallel resonator branch is grounded, and another end of the one parallel resonator branch is connected to the series resonator branch through the parallel resonator unit including the parallel module.
9. The reflectionless filter according to 6, wherein:
   at each of two symmetrical sides of the symmetrical two-port circuit, the symmetrical two-port circuit includes:
      a first series resonator unit that is one of two series resonator units connected in series between two ports;
      a first parallel resonator unit, a second parallel resonator unit and a resistance element, wherein one end of the first parallel resonator unit is connected between a corresponding one of the two ports and the first series resonator unit, another end of the first parallel resonator unit is connected to one end of the resistance element, another end of the resistance element is connected to one end of the second parallel resonator unit, and another end of the second parallel resonator unit is grounded; and
      a third parallel resonator unit, one end of the third parallel resonator unit being connected between the another end of the first parallel resonator unit and the one end of the resistance element, and another end of the third parallel resonator unit being grounded; and
   the another ends of the resistance elements arranged at the two symmetrical sides are electrically connected to each other.
10. The reflectionless filter according to 6, wherein:
   the symmetrical two-port circuit includes:
   a first series resonator unit connected between a first port and a second port;
   a first parallel resonator unit and a first resistance element, one end of the first parallel resonator unit being connected between the first port and the first series resonator unit, and another end of the first parallel resonator unit being connected to one end of the first resistance element;
   a second parallel resonator unit and a second resistance element, one end of the second parallel resonator unit being connected between the second port and the first series resonator unit, and another end of the second parallel resonator unit being connected to one end of the second resistance element;
   a third parallel resonator unit, one end of the third parallel resonator unit being connected with both another end of the first resistance element and another end of the second resistance element, and another end of the third parallel resonator unit being grounded;
   a fourth parallel resonator unit, one end of the fourth parallel resonator unit being connected between the another end of the first parallel resonator unit and the one end of the first resistance element, and another end of the fourth parallel resonator unit being grounded; and
   a fifth parallel resonator unit, one end of the fifth parallel resonator unit being connected between the another end of the second parallel resonator unit and the one end of the second resistance element, and another end of the fifth parallel resonator unit being grounded.
11. The reflectionless filter according to any one of 2 to 5 and 7 to 10, wherein
   resistance of the resistance element is equivalent to or the same as a port impedance.
12. An electronic device includes the reflectionless filter according to any one of 1 to 11. It should be noted that the electronic device herein includes, but is not limited to, an intermediate product such as an RF front end, a filtering and amplifying module, and a terminal product such as a mobile phone, WIFI and a drone.
13. The electronic device according to 12, wherein
   the electronic device includes a cascade unit composed of a plurality of the reflectionless filters cascaded with each other.
14. The electronic device according to 13, wherein
   the electronic device includes a filter assembly that includes an input port, an output port, an LC reflectionless bandpass filter, and at least one reflectionless filter according to any one of 1 to 11, wherein the at least one reflectionless filter and the LC reflectionless bandpass filter are sequentially connected in series between the input port and the output port.
15. The electronic device according to 14, wherein
   the electronic device includes a cascade unit composed of a plurality of the reflectionless filters cascaded with each other, and the cascade unit and the LC reflectionless bandpass filter are sequentially connected in series between the input port and the output port.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A reflectionless filter, comprising:
a symmetrical two-port circuit comprising a plurality of series resonator branches and a plurality of parallel resonator branches, each of the plurality of series resonator branches being provided with a series resonator unit, and each of the plurality of parallel resonator branches being provided with a parallel resonator unit,
wherein each of the plurality of series resonator unit comprises a parallel module formed by a bulk acoustic wave resonator and an inductor that are connected in parallel to each other, and the parallel resonator units of at least two of the plurality of parallel resonator branches each comprise a series module formed by a bulk acoustic wave resonator and an inductor that are connected in series to each other.

2. The reflectionless filter according to claim 1, wherein two parallel resonator branches of the plurality of parallel resonator branches arranged at two symmetrical sides of the symmetrical two-port circuit each comprise a resistance element connected between two parallel resonator units of the two parallel resonator branches.

3. The reflectionless filter according to claim 1, wherein one parallel resonator branch of the plurality of parallel resonator branches arranged at each of two symmetrical sides of the symmetrical two-port circuit comprises a parallel resonator, the parallel resonator comprises a parallel module formed by a bulk acoustic wave resonator and an inductor that are connected in parallel to each other, one end of the one parallel resonator branch is grounded, and another end of the one parallel resonator branch is connected to one of the plurality of series resonator branches through the parallel resonator unit comprising the series module.

4. The reflectionless filter according to claim 1, wherein at each of two symmetrical sides of the symmetrical two-port circuit, the symmetrical two-port circuit comprises:
a first series resonator unit that is one of two series resonator units of the plurality of series resonator unit, the two series resonator units being connected in series between two ports of the symmetrical two-port circuit;
a first parallel resonator unit, a second parallel resonator unit and a resistance element, one end of the first parallel resonator unit being connected between a corresponding one of the two ports and the first series resonator unit, another end of the first parallel resonator unit being connected to one end of the resistance element, another end of the resistance element being connected to one end of the second parallel resonator unit, and another end of the second parallel resonator unit being grounded; and
a third parallel resonator unit, one end of the third parallel resonator unit being connected between another end of the first parallel resonator unit and the one end of the resistance element, and another end of the third parallel resonator unit being grounded; and
the another ends of the resistance elements at the two symmetrical sides are electrically connected to each other.

5. The reflectionless filter according to claim 1, wherein the symmetrical two-port circuit comprises:
a first series resonator unit connected between a first port and a second port of the symmetrical two-port circuit;
a first parallel resonator unit and a first resistance element, one end of the first parallel resonator unit being connected between the first port and the first series resonator unit, and another end of the first parallel resonator unit being connected to one end of the first resistance element;
a second parallel resonator unit and a second resistance element, one end of the second parallel resonator unit being connected between the second port and the first series resonator unit, and another end of the second parallel resonator unit being connected to one end of the second resistance element;
a third parallel resonator unit, one end of the third parallel resonator unit being connected with both another end of the first resistance element and another end of the second resistance element, and another end of the third parallel resonator unit being grounded;
a fourth parallel resonator unit, one end of the fourth parallel resonator unit being connected between the another end of the first parallel resonator unit and the one end of the first resistance element, and another end of the fourth parallel resonator unit being grounded; and
a fifth parallel resonator unit, one end of the fifth parallel resonator unit being connected between the another end of the second parallel resonator unit and the one end of the second resistance element, and another end of the fifth parallel resonator unit being grounded.

6. A reflectionless filter, comprising:
a symmetrical two-port circuit comprising a plurality of series resonator branches and a plurality of parallel resonator branches, each of the plurality of series resonator branches being provided with a series resonator unit, and each of the plurality of parallel resonator branches being provided with a parallel resonator unit,
wherein the series resonator unit comprises a series module formed by a bulk acoustic wave resonator and an inductor that are connected in series to each other, and the parallel resonator units of at least two of the plurality of parallel resonator branches each comprise a parallel module formed by a bulk acoustic wave resonator and an inductor that are connected in parallel to each other.

7. The reflectionless filter according to claim 6, wherein two parallel resonator branches of the plurality of parallel resonator branches arranged at two symmetrical sides of the symmetrical two-port circuit each comprise a resistance element connected between two parallel resonator units of the two parallel resonator branches.

8. The reflectionless filter according to claim 6, wherein one of parallel resonator branches of the plurality of parallel resonator branches arranged at each of two symmetrical sides of the symmetrical two-port circuit is provided with a parallel resonator, the parallel resonator comprises a series module formed by a bulk acoustic wave resonator and an inductor that are connected in series to each other, one end of the one parallel resonator branch is grounded, and another end of the one parallel resonator branch is connected to the series resonator branch through the parallel resonator unit comprising the parallel module.

9. The reflectionless filter according to claim 6, wherein at each of two symmetrical sides of the symmetrical two-port circuit, the symmetrical two-port circuit comprises:
a first series resonator unit that is one of two series resonator units connected in series between two ports of the symmetrical two-port circuit;
a first parallel resonator unit, a second parallel resonator unit and a resistance element, one end of the first parallel resonator unit being connected between a corresponding one of the two ports and the first series resonator unit, another end of the first parallel resonator unit being connected to one end of the resistance element, another end of the resistance element being connected to one end of the second parallel resonator unit, and another end of the second parallel resonator unit being grounded; and
a third parallel resonator unit, one end of the third parallel resonator unit being connected between the another end of the first parallel resonator unit and the one end of the resistance element, and another end of the third parallel resonator unit being grounded; and
the another ends of the resistance elements arranged at the two symmetrical sides are electrically connected to each other.

10. The reflectionless filter according to claim 6, wherein the symmetrical two-port circuit comprises:
a first series resonator unit connected between a first port and a second port of the symmetrical two-port circuit;
a first parallel resonator unit and a first resistance element, one end of the first parallel resonator unit being connected between the first port and the first series resonator unit, and another end of the first parallel resonator unit being connected to one end of the first resistance element;
a second parallel resonator unit and a second resistance element, one end of the second parallel resonator unit being connected between the second port and the first series resonator unit, and another end of the second parallel resonator unit being connected to one end of the second resistance element;
a third parallel resonator unit, one end of the third parallel resonator unit being connected with both another end of the first resistance element and another end of the second resistance element, and another end of the third parallel resonator unit being grounded;
a fourth parallel resonator unit, one end of the fourth parallel resonator unit being connected between the another end of the first parallel resonator unit and the one end of the first resistance element, and another end of the fourth parallel resonator unit being grounded; and
a fifth parallel resonator unit, one end of the fifth parallel resonator unit being connected between the another end of the second parallel resonator unit and the one end of the second resistance element, and another end of the fifth parallel resonator unit being grounded.

11. The reflectionless filter according to any one of claims 2 to 5 and 7 to 10, wherein resistance of the resistance element is equivalent to or the same as a port impedance.

12. An electronic device comprising the reflectionless filter according to any one of claims 1 to 11.

13. The electronic device according to claim 12, further comprising:
a cascade unit composed of a plurality of the reflectionless filters cascaded with each other.

14. The electronic device according to claim 12, further comprising:
a filter assembly comprising an input port, an output port, an LC reflectionless bandpass filter, and at least one reflectionless filter according to any one of claims 1 to 11,
wherein the at least one reflectionless filter and the LC reflectionless bandpass filter are sequentially connected in series between the input port and the output port.

15. The electronic device according to claim 14, further comprising:
a cascade unit composed of a plurality of the reflectionless filters cascaded with each other, the cascade unit and the LC reflectionless bandpass filter being sequentially connected in series between the input port and the output port.
